# EUROPEAN PATENT APPLICATION

(11) **EP 1 387 215 A1**
(43) Date of publication of application: **04.02.2004**
(21) Application number: 03016423.0
(22) Date of filing: 21.07.2003
(51) Int. Cl.: G03F 7/00, G03H 1/02, G03F 7/11, G02B 5/30

(54) **Optical element resistant to pressure-induced defects**

(30) Priority: 01.08.2002 US 210763
(71) Applicant: E.I.Du Pont de Nemours and Company, Wilmington, Deleware 19898 (US)
(72) Inventor: Felder, Thomas C., Kennett Square, Pennsylvania 19348 (US); Fickes, Michael G., Kennett Square, Pennsylvania 19348 (US); Hewitt Stevenson, Sylvia, Wilmington, Delaware 19810 (US)
(74) Representative: Thomson, James B.

(57) **Abstract**

An optical element is disclosed that is resistant to pressure-induced defects and which contains a hologram, an optical diffuser, a microlens array or a lens. The optical element is useful as a component in liquid crystal displays (LCDs) or other types of displays.

## Description

### BACKGROUND OF THE INVENTION

### Field of the Invention

This invention pertains to an optical element containing a hologram, optical diffuser, microlens array or lens that is resistant to pressure-induced defects.

### Description of Related Art

A photopolymer optical element (e.g., one containing a hologram, optical diffuser, microlens array or lens) is relatively soft, and consequently has an undesirable propensity for shifting color in areas where physical pressure is applied, such as from support struts below or sealing gaskets around the optical element. This color-shifting problem is increasing in frequency as holographic, diffusive, microlens array, or lens elements are being installed in more portable electronic devices, where space is highly constrained and where all elements often need to be squeezed into position.

Ohtaki et al. (Practical Holography XIV and Holographic Materials VI, S. A. Benton, S. H. Stevenson, and T. J. Trout, eds., Proceedings of SPIE, Vol. 3956 (2000) p. 245-252) addresses pressure-induced color changes in photopolymer holograms by hardening adhesives adjacent to the hologram. A relationship is disclosed between the Dynamic Storage Modulus of the adhesive and the sensitivity of the adjacent hologram to pressure-induced defects. The hardness of the adhesive is increased by increasing the levels of multifunctional monomers in the adhesive formulation. This approach leads to a shift in the color of the adjacent hologram. It is often desirable to closely maintain the color of the original hologram. In addition, the degree of defect resistance is insufficient for many applications where concentrated pressure is continuously applied on the photopolymer hologram, such as adjacent to a pressure-activated LED backlight or in contact with casing gaskets used for hermetic sealing. Thus, the approach taken by Ohtaki et al. is not appropriate in all cases, and a need remains to strengthen resistance to pressure defects while maintaining the original color of the photopolymer hologram.

### SUMMARY OF THE INVENTION

An optical element comprises a photopolymer layer containing a hologram, optical diffuser, microlens array or lens for use with a liquid crystal display disposed adjacent a first surface of the photopolymer layer. The optical element comprises an additional layer disposed adjacent a side of the photopolymer layer opposite the first surface, wherein the additional layer contains a cellulose ester polymer having a hardness of at least 16 Knoops. The additional layer may comprise a color tuning layer.

### BRIEF DESCRIPTION OF THE DRAWINGS

Figure 1 is a diagrammatic elevation view illustrating an optical element according to the invention.
Figure 2 is a diagrammatic elevation view illustrating a typical holographic reflector that was used to test for resistance to pressure-induced defects.

### DETAILED DESCRIPTION OF THE PREFERRED EMBODIMENTS

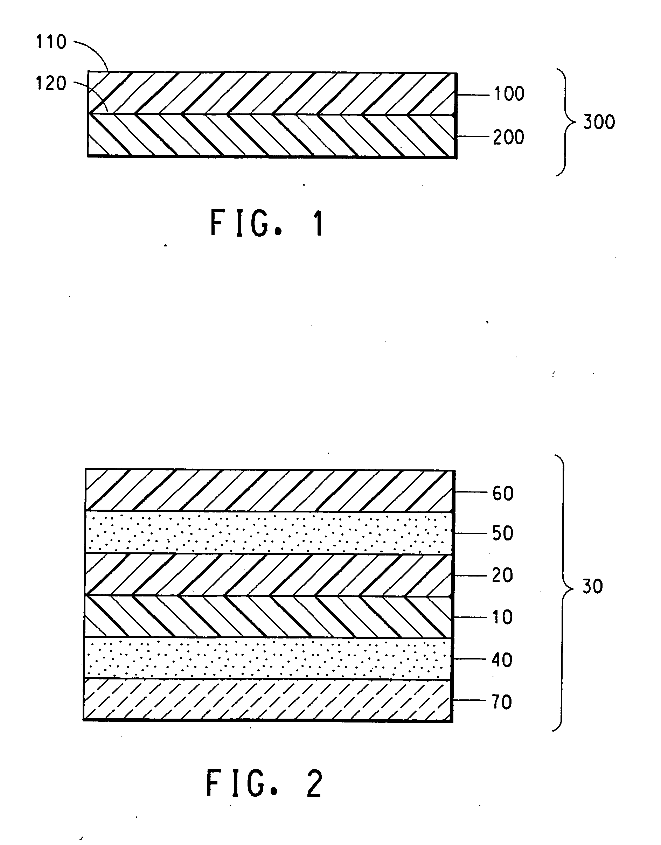

Figure 1 shows an optical element 300 comprising a photopolymer layer 100, which contains a hologram, optical diffuser, microlens array or lens, and an additional layer 200. The optical element 300 is for use with a liquid crystal display (not shown) disposed adjacent a first surface 110 of the photopolymer layer. The additional layer 200 is disposed adjacent a side 120 of the photopolymer layer 100 that is opposite the first surface 110. Details are given below about the photopolymer layer 100 and the additional layer 200.

### Photopolymer Layer

The photopolymer layer 100 comprises any photopolymerizable or photocrosslinkable composition (prior to imaging) that is sensitive to imaging radiation, e.g., visible, IR or UV, such that the photopolymer layer subsequent to imaging contains either a hologram in case of holographic imaging or a graded refractive index optical diffuser, microlens array or lens in case of non-holographic imaging. Subsequent to imaging, the photopolymer layer 100 comprises photopolymerized or photocrosslinked photopolymer. The photopolymer layer 100 is substantially solid, i.e., a dry film layer.

In cases where the optical element 300 contains a hologram, suitable photopolymerizable compositions for the photopolymer layer 100 are well known to those skilled in the art. Illustrative compositions include those described in US Patents 4,959,283; 4,963,471; and 5, 725,970. Preferred dry film photopolymerizable layers are the photosensitive layers of OmniDex® holographic recording films (HRFs) (E. I. du Pont de Nemours & Co., Inc., Wilmington, DE), such as OmniDex® 706 HRF or OmniDex® 801 HRF.

Also in cases where the optical element 300 contains an optical diffuser or microlens array, suitable photopolymerizable compositions for the photopolymer layer 100 are known to those skilled in the art. Suitable compositions include various photopolymer films, including OmniDex® holographic recording films (HRFs) (E. I. du Pont de Nemours & Co., Inc., Wilmington, DE), with the designation HRF600.

### Additional Layer

The additional layer 200 is substantially solid, i.e., a dry film layer, and can comprise any composition as long as it contains a cellulose ester polymer having a hardness of at least 16 Knoops. If the additional layer 200 does not contain a cellulose ester polymer having a hardness of at least 16 Knoops, the additional layer 200 will not impart to the optical element 300 sufficient protection against pressure-induced defects. For use in displays, preferably the additional layer 200 is transparent or substantially transparent in the visible region of the electromagnetic spectrum.

Illustrative, non-limiting examples of cellulose ester polymers are cellulose formate esters, cellulose acetate esters, cellulose propionate esters, and cellulose butyrate esters. Some illustrative examples of cellulose ester polymers that are cellulose acetate ester polymers are cellulose acetate butyrate and cellulose acetate propionate. (The former is also a cellulose butyrate ester and the latter is also a cellulose propionate ester.)

In one embodiment of this invention, the cellulose ester is selected from the group consisting of cellulose formate ester, cellulose acetate ester, cellulose propionate ester, and cellulose butyrate ester. Various cellulose ester polymers are commercially available from Eastman Chemical Company, Kingsport, TN. Cellulose acetate ester polymers are especially advantageous to the current invention since many requirements for film binder are met, including solubility in commercially practical solvents, good miscibility with other materials needed to impart specialized properties, and hardness adequate to meet requirements of the current invention.

When the cellulose ester polymer is cellulose acetate butyrate, the polymer preferably contains at least 5% by weight of acetate groups and less than 48% by weight of butyrate groups; more preferably contains at least 10% by weight of acetate groups and less than 45% by weight of butyrate groups; and still more preferably contains at least 12% by weight of acetate groups and less than 40% by weight of butyrate groups. When a cellulose acetate butyrate polymer contains greater than 48% by weight of butyrate, it's hardness is too low for the polymer to be useful in the additional layer to afford significant increased resistance to pressure-induced defects.

As is true for polymers in general, the hardness of a given cellulose ester polymer depends upon a number of factors including:
1) intrinsic properties of the polymer that relate to its stiffness or modulus, determined by the nature of monomers composing the polymer chain, the length of the chain, as well as chemical groups covalently bound to the main polymer chain.
2) level of crosslinking in the polymer, where hardness increases as the density of polymer chain networks increases, and
3) inclusion of inorganic, metal oxide, or metallic particle fillers in the polymer matrix.
Crosslinking of cellulose ester polymers to increase hardness can be effected by reaction of hydroxyl groups present in the cellulose ester polymer with various compounds that have functional groups that are reactive with hydroxyl groups. Illustrative examples include various organic diacids (e.g., adipic acid) and organic diacid chlorides (e.g., diacid chloride of succinic acid).

The hardness of a polymeric material is conveniently determined by observing the penetration depth into the polymer of a geometrically defined stylus under a defined load. This method for measuring hardness is described in ASTM D1474, and hardness values are given in Knoops, where a higher number indicates a harder polymer. Preferably, the polymeric binder of the additional layer 200 has a hardness in the range of 17 Knoops to 30 Knoops. More preferably, the polymeric binder of the additional layer 200 has a hardness in the range of 17 Knoops to 21 Knoops.

The additional layer 200 of the optical element 300 can comprise a color tuning layer which, in cases where the photopolymer layer 100 contains a hologram, alters the wavelength of response of the hologram as discussed in more detail below. The additional layer 200 of the optical element 300 can comprise a layer which, in cases where the photopolymer layer 100 contains a hologram, is suitable for converting the hologram into a broad band hologram as disclosed in U.S. Patent 5,725,970.

### Color Tuning Layer

A color tuning (diffusion) layer in contact with the photopolymer layer 100 containing a hologram can be used to adjust the wavelength response (i.e., the playback wavelength) of the hologram as described in U.S. Patent 4,959,283 and related patents.

With respect to the present invention, after the photopolymer layer 100 has been imaged to contain a hologram, the photopolymer layer 100 is placed in contact with a color tuning layer 200, as described in U.S. Patent 4,959,283, to produce the optical element 300. Contact of these two layers results in modification of the wavelength of light characteristic of the hologram, i.e., modifies the wavelength of light reflected by the hologram in case of a reflection hologram.

A preferred color tuning layer contains a diffusion agent (e.g., a monomer and/or plasticizer) that will diffuse into and swell the photopolymer layer containing a hologram. This diffusion of diffusion agent into the photopolymer layer causes the photopolymer layer to swell and thereby increases the wavelength of response of the hologram in the swelled photopolymer layer. Intimate contact is required to achieve uniform diffusion over the surface of the photopolymer layer. Thus, the color tuning layer generally will be a film, containing the diffusion agent(s), that can readily be laminated to the photopolymer layer, or a coating composition that, when dried, adheres to the photopolymer layer. In many applications it will be desired to retain the color tuning layer in place after it has served the purpose of processing the hologram. Thus, the color tuning layer generally has sufficient clarity that it will not unduly interfere with use of the optical element (comprising the color tuning layer and the photopolymer layer containing a hologram) in applications where light must pass through the color tuning layer.

The primary component of the color tuning layer is a cellulose ester polymer specifically selected to have a hardness of at least 16 Knoops, and the diffusion agent is conveniently a monomer or plasticizer employed in the photopolymer layer, or a compatible material having a similar refractive index. Selection of these materials readily achieves alteration of wavelength response of the hologram, without unduly affecting properties of the optical element or requiring a subsequent step of removing the color tuning layer after its purpose of wavelength alteration has been achieved.

The amount of diffusion agent contained in the color tuning layer must be sufficient to achieve the desired shift in wavelength response. The level of diffusion is readily monitored by exposing the photopolymer layer of the optical element to incident light of the desired wavelength. When the desired shift has been obtained, further diffusion is arrested. If the diffusion agent is a monomer, further diffusion is stopped, and the shift in response wavelength is "fixed", by polymerizing the monomer. Polymerization is readily achieved by flooding the photopolymer layer and color tuning layer with light having the appropriate wavelength, typically ultraviolet light, or by heating the photopolymer layer and color tuning layer while in intimate contact to the appropriate temperature. Alternatively, the color tuning layer may be removed from the photopolymer layer when the desired shift has been achieved, or the color tuning layer may contain the exact level of diffusion agent that produces the desired shift at equilibrium.

In another case, the color tuning layer absorbs plasticizer or other diffusable material contained in the photopolymer layer of the optical element, thereby causing shrinkage and a decrease in the wavelength response of the hologram e.g., a decrease in the wavelength of light reflected by the hologram in case of a reflection hologram. As in the first case described above, the color tuning layer in this case conveniently is primarily composed of the binder employed in the photopolymer layer or a similar material, to enhance intimate contact between the photopolymer and color tuning layers (achieved by laminating or coating the color tuning layer to the photopolymer layer to form the diffusion element), and to provide a material into which the diffusion agent(s) will diffuse. The extent of diffusion is monitored and the color tuning layer is removed when the desired shift has been achieved. Alternatively, a color tuning layer may be selected that absorbs the exact level of plasticizer needed to produce the desired shift at equilibrium.

The rate of diffusion is affected by the temperature of the color tuning layer and the photopolymer layer. Thus effecting wavelength response shifts with the color tuning layer may be achieved more readily if the color tuning and photopolymer layers are heated while in contact provided that extreme temperatures are avoided that would cause degradation of either of these layers, or, in the case of monomer diffusion, premature polymerization.

### Holographic Imaging

Holograms are recorded using coherent light sources, such as lasers. In recording a hologram, two beams of coherent radiation, known as object beam and reference beam, are allowed to simultaneously enter the recording medium. The interference between these beams is recorded by the recording medium as a spatial pattern of varying refractive index.

Reflection holograms, i.e., holograms which are viewed in reflection, are formed by allowing the object beam and the reference beam to enter the recording medium from opposite sides so that they are traveling in approximately opposite directions. Reflection holograms may be produced by an on-axis method wherein the reference beam is projected through the recording medium onto an object there behind. The reflected beam becomes the object beam and interferes with the reference beam. Reflection holograms produced by an on-axis process are disclosed in an article by Yu N. Denisyuk entitled "Photographic Reconstruction of the Optical Properties of an object in its Own Scattered Radiation Field," published in Soviet Physics-Doklady, Vol. 7, pages 543-5 (1962). Also see an article by Clark N. Kunyz entitled "Copying Reflection Holograms" published in the Journal of the Optical Society of America, 58, pages 856-7 (1968). Reflection holograms also may be produced by an off-axis method wherein a reference beam is projected on one side of the recording medium and an object beam is projected on the reverse side of the medium. Reflection holograms produced by an off-axis process are disclosed in Hartman, U.S. Patent 3,532,406.

A holographic mirror is the simplest possible reflection hologram. It can be created by splitting a laser beam and recombining the beams at the recording medium (off-axis method). Alternatively, it can be created by projecting a laser beam through the recording medium onto a mirror (on-axis method). The light reflected by the mirror becomes the object beam, returning and interfering with the reference beam in the plane of the recording medium. In one process, the coversheet is removed and a reflective film such as aluminized polyethylene terephthalate, is laminated to the holographic recording material with the aluminized side in contact with the holographic recording material. Since the holographic recording material can adhere to the aluminized surface, this step is preferably carried out immediately prior to holographic exposure. Holographic exposure is then carried out through the support. The reflective film acts as a mirror during holographic exposure.

Transmission holograms, i.e., holograms which are viewed in transmission, are formed by allowing both the object beam and the reference beam to enter the recording medium from the same side of the recording medium. In this invention, the photosensitive layer of the optical element following holographic imaging can contain either a transmission hologram or a reflection hologram.

Holographic imaging is well known to those skilled in the art. Additional details about holographic imaging are given in many patents, including US Patents 4,959,283; 4,963,471; and 5,725,970.

### Photopolymer Diffusers, Microlens Arrays and Lenses

Photopolymers have proven to be a convenient material to produce a variety of optical elements based on the diffraction of light. Varying refractive indices within a coating have been produced by non-holographic, so called "single-beam" exposures. Representative patents and patent publications that disclose non-holographic imaging to produce diffusers in a recording medium include U.S. Patent 5,365,354 and PCT patent publications WO 98/39755 and WO 00/41009; microlens arrays are disclosed in EP 0294122 and Croutxe-Barghorn, et al, *Eur. Phys J.: Appl. Phys.* (2001), 13(1) 31-37; lenses are disclosed in EP 728572 A2.

### Industrial Applicability

The optical elements of this invention have significantly increased resistance to pressure-induced defects being produced within them. These elements are useful in liquid crystal displays (LCDs) as well as other displays for enhancing the overall display characteristics, such as increasing contrast, etc. The use of these elements in displays results in higher quality and more defect-free displays.

### EXAMPLES

The advantageous properties of this invention can be observed by reference to the following examples which illustrate, but do not limit, the invention. In these examples, parts and percentages are by weight unless otherwise indicated. Terms or abbreviations used in the examples and/or elsewhere in the specification are defined in the following glossary.

| GLOSSARY | |
|---|---|
| CTF | Color tuning film |
| o-CI-HABI | 2,2'-bis(2-chlorophenyl)-4,4',5,5'-tetraphenyl-1,1'-bi-1H-imidazole (symmetric N-N dimer); CAS 1707-68-2 and/or |
| | 2-(2-chlorophenyl)-1-[2-(2-chlorophenyl)-4,5-diphenyl-2H-imidazol-2-yl]-4,5-diphenyl-1 H-imidazole (asymmetric1,2'-NC dimer) CAS 7189-82-4 Hampford Research, Inc. (Stratford, CT) |
| FC-430 | Fluorad® FC-430; fluoroaliphatic polymeric esters; 3M Company, St. Paul, MN CAS 11114-17-3 |
| Imaged HRF MMT | Imaged holographic recording film 4-Methyl-4H-1,2,4-triazole-3-thiol; Hampford Research, Inc. (Stratford, CT) CAS 24854-43-1 |
| Ph-4039 | Photomer® 4039 (Phenol ethoxylate monoacrylate); Cognis, Ambler, PA CAS 56641-05-5 |
| SR-349 | Sartomer® 349 (Ethoxylated bisphenol A diacrylate); Sartomer, West Chester, PA, CAS 24447-78-7 |
| TAOBN | 1,4,4-Trimethyl-2,3 diazobicyclo-(3.2.2)-non-2-ene-2,3-dioxide; Hampford Research, Inc. (Stratford, CT) CAS 34122-40-2 |

### Test Procedure for Optical Elements

The general test procedure outlined here was used in both the examples and comparative examples given below for evaluating the relative propensities for holographic optical elements to undergo pressure induced defects. In each case, a holographic reflector was assembled in a stack structure as follows:

Film Base / Adhesive / CTF / HRF / Adhesive / Glass

where "/" indicates an interface in which adjacent layers of the stack structure contact each other.

Figure 2 shows a typical holographic reflector 30 that was used in this test procedure. In Figure 2, layer 70 was glass; layer 40 was an adhesive; layer 10 was a reflection hologram (imaged HRF that contains a reflection hologram) that appeared uniformly green (in the absence of pressure-induced defects); layer 20 was a color tuning film (CTF); layer 50 was an adhesive; and layer 60 was the film base.

More specifically, the characteristics of the individual layers of the holographic reflector used in these examples and comparative examples are summarized below.

The glass was float glass or glass slides (from Corning Glass Works, Corning, NY).

The adhesive layer 40 was AD20 (from Polatechno Co. Ltd., Niigatigen, Japan) in all examples. Adhesive layer 50 was ACM (from Nippon Paper Industries, Tokyo, Japan) (in Examples 1-6 and Comparative Example 1), 8154 (from Adhesives Research, Inc. Glen Rock, PA) (in Example 7), 8141, 8142, 9447, 9457, 989, and 300LSE (from 3M Adhesives Division, St Paul, MN) (in Example 7).

The hologram used in layer 10 was a blue (prior to color tuning) reflection hologram that was obtained by holographic imaging of OmniDex® 706 HRF (E. I. du Pont de Nemours & Co., Inc., Wilmington, DE) using a Ar+ laser as coherent light source operating at 476 nm. Further details for the holographic imaging are given as in US Patent 5,182,180 and US Patent 5,725,970.

The color tuning film in each example or comparative example had the following composition:

| Component | Weight % |
|---|---|
| Binder | 53 |
| SR-349 | 11 |
| Ph-4039 | 30.87 |
| o-CI-HABI | 2.5 |
| MMT | 2.5 |
| FC-430 | 0.1 |
| TAOBN | 0.03 |

The choice of binder was varied from one example or comparative example to another as indicated below.

The HRF layer 10 and CTF layer 20 were laminated to each other and baked at 130-155°C for 5-10 minutes to effect color tuning prior to being assembled into the stack structure with the adhesive and other layers. The resulting hologram subsequent to this baking, which resulted in color tuning, was a uniform green color.

The film base layer 60 was a partially reflective film STR000 or STR400 from (Nippon Paper Industries, Tokyo, Japan).

In each case, a given holographic reflector containing a given binder was subjected to the following procedure to test for pressure defect sensitivity.

Three steel ball bearings were glued to a glass slide in a triangular arrangement to form a testing tool. In each case, the holographic reflector was assembled as was described supra. The stack structure of the holographic reflector that was used is illustrated in Figure 2. The reflector was placed in an oven glass side down. The testing tool was laid onto the reflector such that the ball bearings rested upon the film base. Weights (up to 630 grams) were then laid on the testing tool, and the resulting assembly was held at 70°C for 1 hour. The reflector was subsequently removed from the oven, the testing tool was removed from the reflector, and the reflector was allowed to cool to ambient temperature. Subsequently, the reflector was inspected for the presence of pressure-induced defect(s).

For the inspection for pressure-induced defect(s), a rating scale ranging from 1 to 10 was established as follows:
- 10: no observable defect was present and the hologram remained uniformly green after completion of testing.
- 6-9: at least one blue spot of low to medium intensity and diameter was present at location(s) where the ball bearings had rested during testing.
- 5: at least one blue spots of moderate intensity was present at location(s) where the ball bearings had rested during testing.
- 2-4: at least one blue spot of medium to high intensity and diameter was present at location(s) where the ball bearings had rested during testing.
- 1: observable defects were observed instantaneously upon conducting the test and 3 relatively large diameter blue spots of high intensity were present at locations where the ball bearings had rested during testing.

In each case for this rating scale, a higher number indicates fewer or no defects relative to a lower number.

### Example 1

In this example, the binder of the color tuning film (CTF) was cellulose acetate butyrate, which contained 37 weight % butyrate content and 13.5 weight % acetyl content (at triester weight %). This particular cellulose ester binder is available from Eastman Chemical Company (Kingsport, TN) and is designated CAB-381-20 in the Eastman catalog. This binder has a Tukon hardness as determined by ASTM D 1474 of 18 Knoops.

A holographic reflector was prepared and tested with 31.2 g weight applied to the testing tool as described supra for this CTF. The holographic reflector in this example was determined to have a rating of 8 in the above-described testing and thus has relatively high resistance to pressure-induced defects being formed.

### Example 2

In this example, the binder of the color tuning film (CTF) was cellulose acetate propionate, which contained 50 weight % propionate content and 0.6 weight % acetyl content (at triester weight %). This particular cellulose ester binder is available from Eastman Chemical Company (Kingsport, TN) and is designated CAP-504-0.2 in the Eastman catalog. This binder has a Tukon hardness as determined by ASTM D 1474 of 20 Knoops.

A holographic reflector was prepared and tested with 31.2 g weight applied to the testing tool as described supra for this CTF. The holographic reflector in this example was determined to have a rating of 7 in the above-described testing and thus has moderately high resistance to pressure-induced defects being formed.

### Example 3

In this example, the binder of the color tuning film (CTF) was cellulose acetate butyrate, which contained 31.2 weight % butyrate content and 18.5 weight % acetyl content (at triester weight %). This particular cellulose ester binder is available from Eastman Chemical Company (Kingsport, TN) and is designated CAB-321-0.1 in the Eastman catalog. This binder has a Tukon hardness as determined by ASTM D 1474 of 21 Knoops.

A holographic reflector was prepared and tested with 31.2g weight applied to the testing tool as described supra for this CTF. The holographic reflector in this example was determined to have a rating of 9 in the above-described testing and thus has a high resistance to pressure-induced defects being formed.

### Example 4

In this example, the binder of the color tuning film (CTF) was cellulose acetate butyrate, which contained 17 weight % butyrate content and 29.5 weight % acetyl content (at triester weight %). This particular cellulose ester binder is available from Eastman Chemical Company (Kingsport, TN) and is designated CAB-171-15S in the Eastman catalog. This binder has a Tukon hardness as determined by ASTM D 1474 of 27 Knoops.

A holographic reflector was prepared and tested with 31.2g weight applied to the testing tool as described supra for this CTF. The holographic reflector in this example was determined to have a rating of 9 in the above-described testing and thus has a high resistance to pressure-induced defects being formed.

### Comparative Example 1

In this example, the binder of the color tuning film (CTF) was cellulose acetate butyrate, which contained 50 weight % butyrate content and 3 weight % acetyl content (at triester weight %). This particular cellulose ester binder is available from Eastman Chemical Company (Kingsport, TN) and is designated CAB-531-1 in the Eastman catalog. This binder has a Tukon hardness as determined by ASTM D 1474 of 15 Knoops.

A holographic reflector was prepared and tested with 31.2g weight applied to the testing tool as described supra for this CTF. The holographic reflector in this example was determined to have a rating of 1 in the above-described testing and thus has very low resistance to pressure-induced defects being formed (i.e., very significant defects were present and appeared early-on during testing).

### Example 5

This example illustrates maintenance of holographic color characteristics when different binders having high Tukon hardness are substituted in color tuning film (CTF) in place of a standard binder having relatively low Tukon hardness.

The reflectance spectra of the samples in the above examples following color tuning were recorded on a PhotoResearch PR650 photodiode spectrophotometer to determine the effect of the CTF on holographic properties. Samples were irradiated with white light, and reflectance spectra were taken at the angle of maximum diffraction. Brightness was recorded in Cd/sqm (candelas/square meter). Dominant Lamda is the equivalent monochromatic wavelength calculated from the observed spectrum (as described in G. Wyszecki and W. Stiles, Color Science, 2^{nd} Ed., John Wiley and Sons, New York (1982), p. 175), and BW50 is the spectral bandwidth at half-maximum brightness. The results obtained are summarized in the table below.

| CTF | Binder hardness | Cd/sqm | Dominant Lambda | BW50 |
|---|---|---|---|---|
| Comp Ex 1 | 15 | 6404 | 558nm | 65nm |
| Example 1 | 18 | 7549 | 563nm | 66nm |
| Example 3 | 21 | 6030 | 567nm | 49nm |
| Example 2 | 24 | 6444 | 570nm | 96nm |
| Example 4 | 27 | 6864 | 582nm | 43nm |

While all color tuning films (CTFs) in Examples 1-4 provide improved resistance to pressure defects relative to the CTF of Comparative Example 1, the closest match to the color and other holographic properties of Comparative Example 1 is given by the CTF used in Example 1. The CTF of Comparative Example 1 is representative of what is currently used by those skilled in the art for effecting color tuning to alter the wavelength of response of a hologram (i.e., alter wavelength at which the hologram efficiently reflects incident light).

### Example 6

In this example, holographic reflectors were prepared as indicated supra using the CTF in Comparative Example 1 and the CTF in Example 1. A modified pressure test simulating a wider-area pressure defect was employed. Holographic reflectors were laid into an oven with the glass side down. A 3 mil polycarbonate sheet was laid on the reflectors and a ball bearing tool was placed over each reflector. Weights totaling 630 g were then laid atop the testing tool, and the oven was brought to 70°C and held at this temperature for one hour. The assembly was then removed from the oven and disassembled. The holographic reflectors were returned to room temperature and were then inspected for discoloration. All reflectors made with the CTF in Comparative Example 1were observed to have deeply colored blue spots (equivalent to a "1" rating as specified supra), while the reflectors made with the CTF in Example 1 were observed to exhibit only a slight discoloration where pressure had been applied (equivalent to a "8" rating as specified supra).

In the manner specified above, holographic properties of four samples made from each CTF were determined and averaged; the results that were obtained are presented in the table below. "Brt X White" is the reflected brightness normalized against a diffuse white reflector (Spectralon SRS-99-10 reflector from Labsphere, Inc., North Sutton, NH). "AOV" is the vertical angular span over which the hologram maintains at least 50% of its maximum brightness

| CTF | Brt X white | Dominant Lambda | AOV |
|---|---|---|---|
| Comp Ex 1 | 4.8 ± 0.3 | 553.3 nm ± 2.1 | 17.0° ± 1.1 |
| Example 1 | 4.8 ± 0.3 | 552.6 nm ± 3.6 | 16.8° ± 0.7 |

With the CTF of Example 1 holographic properties are well preserved relative to those using the CTF of Comparative Example 1, while considerable protection against pressure defects has been imparted.

### Example 7

In this example, color tuning film used in Example 1 is referred to as "A" and the color tuning film used in Comparative Example 1 is referred to as "B". Sample holographic reflectors were prepared in the constructions indicated below. The samples were tested according to the procedure used in Example 1. The results, which are presented in the table below, demonstrate that a variety of adhesives and backings can be used without compromising the pressure resistance of the inventive reflectors, which comprise the "A" color tuning film.

| Construction* | Defect Rating (10 best; 1 worst) |
|---|---|
| STR000 / 8141 / "A" / HRF / AD-20 / Glass | 8 |
| STR000 / 8141 / "B" / HRF / AD-20 / Glass | 2 |
| | |
| STR400 / 8142 / "A" / HRF / AD-20 / Glass | 8 |
| STR400 / 8142 / "B" / HRF / AD-20 / Glass | 1 |
| | |
| STR000 / 8154 / "A" / HRF / AD-20 / Glass | 8 |
| STR000 / 8154 / "B" / HRF / AD-20 / Glass | 2 |
| | |
| STR400 / 300LSE / "A" / HRF / AD-20 / Glass | 9 |
| STR400 / 300LSE / "B" / HRF / AD-20 / Glass | 1 |
| | |
| STR400 / 9447 / "A" / HRF / AD-20 / Glass | 8 |
| STR400 / 9447 / "B" / HRF / AD-20 / Glass | 2 |
| STR400 / 9457 / "A" / HRF / AD-20 / Glass | 8 |
| STR400 / 9457 / "B" / HRF / AD-20 / Glass | 1 |
| | |
| STR400 / 989 / "A" / HRF / AD-20 / Glass | 8 |
| STR400 / 989 / "B" / HRF / AD-20 / Glass | 1 |

| | |
|---|---|
| *The above construction is with reference to the stack structure given supra, i.e., the following: | |

Film Base / Adhesive / CTF / HRF / Adhesive / Glass

## Claims

1. An optical element comprising a photopolymer layer containing a hologram, optical diffuser, microlens array or lens for use with a liquid crystal display disposed adjacent a first surface of the photopolymer layer, the optical element comprising an additional layer disposed adjacent a side of the photopolymer layer opposite the first surface, the additional layer containing a cellulose ester polymer having a hardness of at least 16 Knoops.

2. The optical element of Claim 1 wherein the additional layer comprises a color tuning layer disposed on the surface of the photopolymer layer opposite the first surface.

3. The optical element of Claim 1 wherein the cellulose ester polymer is selected from the group consisting of cellulose formate ester, cellulose acetate ester, cellulose propionate ester, and cellulose butyrate ester.

4. The optical element of Claim 1 wherein the cellulose ester polymer is a cellulose acetate ester and is selected from the group consisting of cellulose acetate butyrate and cellulose acetate propionate.

5. The optical element of Claim 4 wherein the polymer is cellulose acetate butyrate, the polymer containing at least 5 % by weight of acetate groups and less than 48 % by weight of butyrate groups.

6. The optical element of Claim 5 wherein the polymer contains at least 10 % by weight of acetate groups and less than 45 % by weight of butyrate groups.

7. The optical element of Claim 6 wherein the polymer contains at least 12 % by weight of acetate groups and less than 40 % by weight of butyrate groups.

8. The optical element of Claim 1 wherein the cellulose ester polymer has a hardness in the range of 17 Knoops to 30 Knoops.

9. The optical element of Claim 8 wherein the cellulose ester polymer has a hardness in the range of 17 Knoops to 21 Knoops.
